# EUROPÄISCHE PATENTSCHRIFT

(11) **EP 2 777 158 B1**
(45) Veröffentlichungstag und Bekanntmachung des Hinweises auf die Patenterteilung: **16.03.2022**
(21) Anmeldenummer: 12772294.0
(22) Anmeldetag: 05.10.2012
(51) Int. Cl.: H03M 3/00

(54) **VERFAHREN UND DELTA-SIGMA-WANDLER FÜR EIN SENSORSIGNAL, INSBESONDERE EIN SIGNAL EINES DREHRATENSENSORS**
METHOD AND DELTA-SIGMA CONVERTER FOR A SENSOR SIGNAL, MORE PARTICULARLY A SIGNAL OF A ROTATION RATE SENSOR
PROCÉDÉ DE CONVERSION ET CONVERTISSEUR DELTA-SIGMA POUR UN SIGNAL DE CAPTEUR, EN PARTICULIER UN SIGNAL D'UN CAPTEUR DE FRÉQUENCE DE ROTATION

(30) Priorität: 09.11.2011 DE 102011086003
(43) Veröffentlichungstag der Anmeldung: 17.09.2014
(73) Patentinhaber: Robert Bosch GmbH, 70442 Stuttgart (DE)
(72) Erfinder: BUHMANN, Alexander, 72760 Reutlingen (DE)
(86) Internationale Anmeldenummer: PCT/EP2012/069678
(87) Internationale Veröffentlichungsnummer: WO 2013/068182

(56) Entgegenhaltungen:
- US-A1- 2007 075 885
- NORTHEMANN T ET AL: "A digital interface for gyroscopes controlling the primary and secondary mode using bandpass sigma-delta modulation", SENSORS AND ACTUATORS A, ELSEVIER SEQUOIA S.A., LAUSANNE, CH, Bd. 162, Nr. 2, 1. August 2010 (2010-08-01), Seiten 388-393, XP027320468, ISSN: 0924-4247 [gefunden am 2010-06-18]
- RAMAN J ET AL: "A Closed-Loop Digitally Controlled MEMS Gyroscope With Unconstrained Sigma-Delta Force-Feedback", IEEE SENSORS JOURNAL, IEEE SERVICE CENTER, NEW YORK, NY, US, Bd. 9, Nr. 3, 1. März 2009 (2009-03-01), Seiten 297-305, XP011251701, ISSN: 1530-437X
- CHINWUBA D EZEKWE ET AL: "A Mode-Matching Closed-Loop Vibratory Gyroscope Readout Interface With a 0.004/s/ Noise Floor Over a 50 Hz Band", IEEE JOURNAL OF SOLID-STATE CIRCUITS, IEEE SERVICE CENTER, PISCATAWAY, NJ, USA, Bd. 43, Nr. 12, 1. Dezember 2008 (2008-12-01), Seiten 3039-3048, XP011238649, ISSN: 0018-9200, DOI: 10.1109/JSSC.2008.2006465

## Beschreibung

### Stand der Technik

Die vorliegende Erfindung bezieht sich auf einen Delta-Sigma-Wandler für ein Sensorsignal, insbesondere ein Signal eines Drehratensensors, auf ein entsprechendes Verfahren sowie auf ein entsprechendes Computerprogrammprodukt.

Heutige moderne Auswerteschaltungen für Drehratensensoren, basieren auf dem Prinzip eines Delta-Sigma Wandlers mit Kraftkompensation. Insbesondere der Einsatz von Single-Bit-Quantisierern ist durch seine einfache schaltungstechnische Implementierbarkeit zu bevorzugen.

Die Druckschrift DE 10 2005 003 630 A1 offenbart einen Delta-Sigma-Modulator. Diese Druckschrift geht aus von einem Delta-Sigma-Modulator, mit einem schwingfähigen System mit einer Eigenfrequenz, mit einer Elektronik und mit einer Regelschleife, die von dem schwingfähigen System auf die Elektronik und von der Elektronik wieder auf das schwingfähige System wirkt.

Die Dissertation "Readout Techniques for High-Q Micromachined Vibratory Rate Gyroscopes" von Chinwuba David Ezekwe,University of California at Berkeley beschreibt Techniken Delta-Sigma-Modulatoren auszulesen.

Der Artikel "A digital interface for gyroscopes controlling the primary and secondary mode using bandpass sigma-delta modulation" von NORTHEMANN T ET AL, in SENSORS AND ACTUATORS A, ELSEVIER SEQUOIA S.A., LAUSANNE, CH, Bd. 162, Nr. 2, 1. August 2010 (2010-08-01), Seiten 388-393, XP027320468, ISSN: 0924-4247 beschreibt ein digitales Interface für ein Gyroskop.

RAMAN J ET AL offenbart "A Closed-Loop Digitally Controlled MEMS Gyroscope With Unconstrained Sigma-Delta Force-Feedback", in IEEE SENSORS JOURNAL, IEEE SERVICE CENTER, NEW YORK, NY, US, Bd. 9, Nr. 3, 1. März 2009 (2009-03-01), Seiten 297-305, XP011251701 , ISSN: 1530-437X.

Die Druckschrift US2007/075885 offenbart einen Delta-Sigma-Wandler mit einer digitalen Kompensationseinheit, die ein in seiner Varianz anpassbares Dithersignal in Abhängigkeit der Aktivität des digitalen Ausgabesignals des Delta-Sigma-Wandlers als Kompensationssignal generiert.

Das Buch "Understanding Delta-Sigma Data Converters" von Richard Schreier und Gabor C. Temes, 2005, Wiley, beschreibt die direkte Korrelation der Aktivität des Quantisierers mit der Schleifenverstärkung in einem Delta-Sigma-Wandler.

### Offenbarung der Erfindung

Vor diesem Hintergrund werden mit der vorliegenden Erfindung ein Delta-Sigma-Wandler mit Abgleich einer Schleifenverstärkung, weiterhin ein Verfahren, das diesen Delta-Sigma-Wandler verwendet, sowie schließlich ein entsprechendes

Computerprogrammprodukt gemäß den Hauptansprüchen vorgestellt. Vorteilhafte Ausgestaltungen ergeben sich aus den jeweiligen Unteransprüchen und der nachfolgenden Beschreibung.

Der erfindungsgemäße Ansatz kann bei einem Delta-Sigma-Wandler mit Kraftkompensation vorgesehen werden. Ein großer Nachteil der Auswerteschaltungen für Sigma-Delta-Wandler nach Stand der Technik ist die unbestimmte Schleifenverstärkung, nicht nur durch die elektrischen Filter und das Sensorelement, sondern auch durch die Variation in der Quantisiererverstärkung. Dies führt dazu, dass die Signalübertragungsfunktion und Rauschübertragungsfunktion nicht den optimierten Transferfunktionen aus dem Systementwurf entsprechen. Daher muss aus der Spektraldichte eine der Übertragungsfunktionen bestimmt und durch Einspeisung von Rauschen auf die gewünschte Übertragungsfunktion korrigiert werden. Dabei handelt sich aber im Stand der Technik um ein visuelles Verfahren, welches sehr zeitaufwendig ist und nur mit großem Rechenaufwand, Bilderkennungsverfahren, automatisiert werden kann.

Ein Aspekt der Erfindung besteht darin hardwareeffizient die Schleifenverstärkung, bestehend aus Sensorverstärkung, Filterverstärkung, Wandlerverstärkung und Quantisiererverstärkung, zu bestimmen und somit einen einfachen Abgleich am Band-Ende und im Betrieb zu ermöglichen.

Die Erfindung basiert auf der Erkenntnis, dass die Aktivität des Quantisierers eine direkte Korrelation zur vorhandenen Schleifenverstärkung besitzt (s. auch Kapitel 3.3 im Buch "Understanding Delta-Sigma Data Converters" von R. Schreier und G. C. Temes). Die Aktivität

A des Quantisierers kann dabei gemäß dem Zusammenhang A = nₜ/ nₚ bestimmt werden, wobei die Variable nₜ die Anzahl der tatsächlichen Signalpegelwechsel, d.h. Zustandsänderungen und die Variable nₚ die Anzahl der prinzipiell möglichen Signalpegelwechsel oder Zustandsänderungen im betrachteten Zeitintervall bezeichnet. Die Aktivität des Quantisierers lässt sich sehr einfach mit einem Zähler, der die Anzahl der Zustandsänderungen zählt, bestimmen und somit, lässt sich dieser Ansatz auch flächeneffizient in einem ASIC implementieren.

Vorteilhaft an dem hier beschriebenen Ansatz ist nun, dass der notwendige Abgleich der Schleifenverstärkung durch eine einfache Messung der Aktivität bestimmt und somit manuell oder durch einen integrierten Regler auf einen definierten Wert eingestellt werden kann. Hiermit kann eine Verbesserung des digitalen Ausgabesignals, insbesondere des Signal-Rausch-Verhältnisses des digitalen Ausgabesignals, erreicht werden.

Die vorliegende Erfindung schafft einen Delta-Sigma-Wandler für ein Sensorsignal, insbesondere ein Signal eines Drehratensensors,
wobei der Delta-Sigma-Wandler ausgebildet ist, um ein digitales Ausgabesignal unter Verwendung des Sensorsignals auszugeben,
wobei der Delta-Sigma-Wandler eine Regeleinheit aufweist, die ausgebildet ist, um ein Regelsignal auf der Basis einer Häufigkeit von Signalpegelwechseln des digitalen Ausgabesignals zu erzeugen,
und wobei der Delta-Sigma-Wandler eine digitale Kompensationseinheit aufweist, die ausgebildet ist, um ein Kompensationssignal, unter Verwendung des digitalen Ausgabesignals und des Regelsignals auszugeben,
wobei der Delta-Sigma-Wandler weiterhin ausgebildet ist, das digitale Ausgabesignal ferner unter Verwendung des Kompensationssignals auszugeben.

Unter einem Delta-Sigma-Wandler kann vorliegend ein elektrisches Gerät verstanden werden, das Sensorsignale verarbeitet und in Abhängigkeit davon Steuer- und/oder Datensignale ausgibt. Der Delta-Sigma-Wandler kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Unter einem Drehratensensor kann ein Sensor verstanden werden, der die Rotationsgeschwindigkeit eines Körpers misst. Durch Integration lässt sich aus der Rotationsgeschwindigkeit ableiten, um welchen Winkel sich ein Körper innerhalb einer Zeit gedreht hat. Das Messprinzip kann auf der Auswertung der Coriolis-Kraft beruhen, die auf ein mechanisch bewegtes System wirkt. Unter einem Delta-Sigma-Wandler kann ein Analog-Digital-Umsetzer verstanden werden, welcher sich von dem Prinzip der Delta-Modulation ableitet. Das Prinzip kann auf einer groben Messung des Signals mittels eines Quantisierers beruhen. Der dabei entstehende Messfehler kann integriert und über eine Gegenkopplung schrittweise kompensiert werden. Bei dem Quantisierer kann es sich um einen 1-Bit-Quantisierer handeln. Die Häufigkeit von Signalpegelwechseln des digitalen Ausgabesignals kann als Aktivität bezeichnet werden. Unter einer Kompensationseinheit kann eine Einheit verstanden werden, die beispielsweise ein Kalibriersignal und/oder das digitale Ausgabesignal und/oder ein in seiner Varianz anpassbares Dithersignal aufbereitet und ein Kompensationssignal ausgibt. Das Signal-Rausch-Verhältnis eines Signals, hier des digitalen Ausgabesignals, kann mittels des Kompensationssignals optimiert werden.

Unter einem Dithersignal kann im Allgemeinen ein Dither-Rauschen verstanden werden. Das Dither-Rauschen entspricht Weißem Rauschen, jedoch mit dem Unterschied, dass es statistisch anders verteilt ist. Verschiedene Dithersignal-Typen werden aufgrund der Wahrscheinlichkeitsdichte-Funktion ihrer Amplitudenverteilung unterschieden.

Gemäß einer Ausführungsform kann die Regeleinheit der Delta-Sigma-Wandlers ausgebildet sein, um die Häufigkeit der Signalpegelwechsel des digitalen Ausgabesignals mit einem Zähler zu bestimmen. Somit kann die Häufigkeit des Signalwechsels des digitalen Ausgabesignals auch kostengünstig mittels eines in einem ASIC implementierten Zählers bestimmt werden.

Auch ist es günstig, wenn der Delta-Sigma-Wandler einen kraftkompensierten Sensor zur Bereitstellung des Sensorsignals integriert. Ein kraftkompensierter Sensor kann ein analoger kraftkompensierter Sensor mit mikromechanisch gefertigtem Messelement sein. Eine Einheit aus Delta-Sigma-Wandler und kraftkompensiertem Sensor kann als eine MEM-Einheit, d.h. mikro-elektro-mechanische Einheit, und/oder eine analoge Einheit ausgeprägt sein, wodurch besonders vorteilhaft ein kraftkompensiertes delta-sigma-gewandeltes Signal bereitgestellt werden kann.

In einer Ausführungsform der vorliegenden Erfindung kann auch die Regeleinheit derart ausgebildet sein, das Regelsignal auch unter Verwendung einer Kennlinie zu bestimmen. Unter einer Kennlinie kann allgemein eine Darstellung von zwei voneinander abhängigen physikalischen Größen verstanden werden. Eine derartige Ausführungsform der vorliegenden Erfindung bietet den Vorteil einer sehr einfachen Möglichkeit, einen vorbestimmten Zusammenhang zwischen unterschiedlichen Größen in eine Regeleinheit einzuprogrammieren, so dass auch eine schnelle Bereitstellung des Regelungssignals ohne eine großen numerischen oder schaltungstechnischen Aufwand betreiben zu müssen.

Ferner kann die Kennlinie eine Häufigkeit von Signalpegelwechseln des digitalen Ausgabesignals in Abhängigkeit einer Schleifenverstärkung des Delta-Sigma-Wandlers abbilden. Der Delta-Sigma-Wandler kann Sensor, Filter, Wandler und/oder Quantisierer einschließen. Unter einer Schleifenverstärkung kann eine Verstärkung verstanden werden, die aus einer Sensorverstärkung, einer Filterverstärkung, einer Wandlerverstärkung und/oder einer Quantisiererverstärkung besteht. Hierdurch lässt sich sehr vorteilhaft eine schnell einschwingende Regelung implementieren.

Günstig ist es auch, wenn der Delta-Sigma-Wandler ausgebildet ist, das digitale Ausgangssignal unter Verwendung eines 1-Bit-Quantisierers auszugeben. Eine solche Ausführungsform der vorliegenden Erfindung bietet ebenfalls den Vorteil, eine möglichst schnell einschwingende Regelschleife zu implementieren.

In einer Ausführungsform der vorliegenden Erfindung kann die Regeleinheit ausgebildet sein, das Regelsignal derart zu bestimmen, dass es einer veränderbaren Varianz eines Dither-Rauschens entspricht. Hierdurch lässt sich sehr vorteilhaft ein möglichst schnelles Einschwingen des Delta-Sigma-Wandlers erreichen. Unter Dither-Rauschen kann ein Rauschsignal verstanden werden, das in etwa Weißem Rauschen entspricht, jedoch mit dem Unterschied, dass es statistisch anders verteilt ist. Verschiedene Dither-Typen werden aufgrund der Wahrscheinlichkeitsdichte-Funktion ihrer Amplitudenverteilung unterschieden.

Entsprechend einer Ausführungsform der vorliegenden Erfindung kann die Regeleinheit des Delta-Sigma-Wandlers ausgebildet sein, um das Regelsignal unter Verwendung eines gleitendenden Mittelwerts der Häufigkeit von Signalpegelwechseln des digitalen Ausgabesignals zu bestimmen. Auch eine derartige Ausführungsform der vorliegenden Erfindung bietet den Vorteil einer Implementierung einer robusten und schnell einschwingenden Regelschleife.

Weiterhin umfasst die Erfindung auch ein Verfahren zum Erzeugen eines digitalen Ausgangssignals unter Verwendung eines Sensorsignals, welches die folgenden Schritte umfasst:
- Einlesen eines Sensorsignals;
- Delta-Sigma-Wandeln des Sensorsignals in ein digitales Ausgangssignal;
- Bereitstellen eines Regelsignals unter Verwendung einer Häufigkeit von Signalpegelwechseln des digitalen Ausgangssignals;
- Ermitteln eines Kompensationssignals unter Verwendung des digitalen Ausgangssignals und des Regelsignals; und
- Verändern des digitalen Ausgangssignals unter Verwendung des Kompensationssignals.

Zusätzlich schafft die vorliegende Erfindung ein Computerprogramm mit Programmcode, der auf einem maschinenlesbaren Träger wie einem Halbleiterspeicher, einem Festplattenspeicher oder einem optischen Speicher gespeichert sein kann, zur Durchführung und/oder Ansteuerung der Schritte des oben genannten Verfahrens, wenn das Computerprogramm auf einem Delta-Sigma-Wandler, einem Steuergerät, einer Vorrichtung oder einer Datenverarbeitungsanlage ausgeführt wird.

Die Erfindung wird nachstehend anhand der beigefügten Zeichnungen beispielhaft näher erläutert. Es zeigen:
- Fig. 1: ein Blockschaltbild eines Ausführungsbeispiels der vorliegenden Erfindung als Delta-Sigma-Wandler;
- Fig. 2: eine Kennlinie eines Ausführungsbeispiels der vorliegenden Erfindung; und
- Fig. 3: ein Ablaufdiagramm eines Ausführungsbeispiels der vorliegenden Erfindung als Verfahren.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

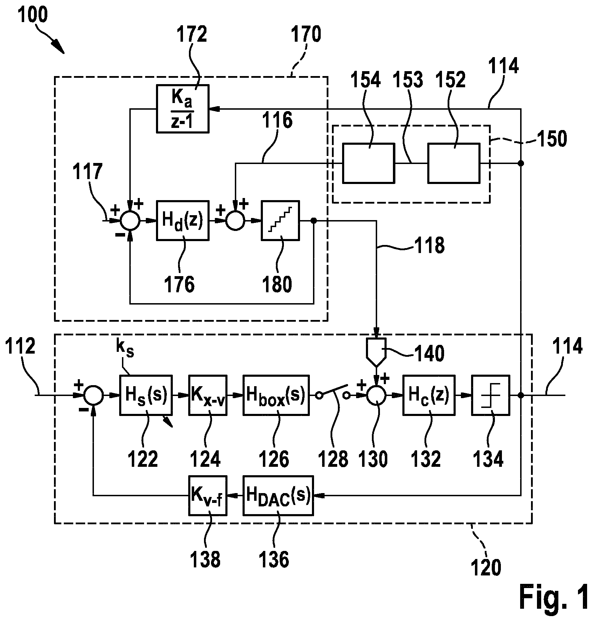

Fig. 1 zeigt ein Blockschaltbild eines Ausführungsbeispiels der vorliegenden Erfindung als Delta-Sigma-Wandler 100. Der Delta-Sigma-Wandler 100 liest einen Wert eines Sensorsignals 112 ein, wobei der Wert eine Coriolis-Kraft eines Drehratensensors repräsentiert, und gibt ein digitales Ausgabesignal 114 aus. Der Delta-Sigma-Wandler 100 besteht aus drei logischen Bereichen, ein Delta-Sigma-Modulator 120, eine Regeleinheit 150 und eine digitale Kompensationseinheit 170. Der Delta-Sigma-Modulator 120 liest das Sensorsignal 112 und ein Kompensationssignal 118 ein und gibt das digitale Ausgabesignal 114 aus. Die Regeleinheit 150 liest das digitale Ausgabesignal ein und gibt ein Regelsignal 116 aus. Die digitale Kompensationseinheit 170 liest das digitale Ausgabesignal 114 und das Regelsignal 116 ein und gibt das Kompensationssignal 118 aus, wobei das Kompensationssignal 118 an den Sigma-Delta-Modulator geleitet wird.

Die Regeleinheit 150 besteht aus zwei Modulen, ein Aktivitätszähler 152 bestimmt aus dem digitalen Ausgabesignal 114 an seinem Eingang die Häufigkeit von Signalpegelwechseln 153 und stellt diese an seinem Ausgang bereit. Die Häufigkeit von Signalpegelwechseln 153 stellt in einem hier nicht dargestellten Ausführungsbeispiel einen gleitenden Mittelwert der Häufigkeit von Signalpegelwechseln 153 dar und stellt dann diesen gleitenden Mittelwert am Ausgang des Aktivitätszählers 152 zur weiteren Verarbeitung bereit. Ein Aktivitätsregler 154 liest an seinem Eingang die Häufigkeit von Signalpegelwechseln 153 ein und stellt an seinem Ausgang das Regelsignal 116 zur Verfügung.

Die digitale Kompensationseinheit liest an einem Eingang das digitale Ausgabesignal 114 ein und leitet dies über einen Akkumulator 172; das resultierende Signal nach dem Akkumulator 172 wird mit einem Kalibriersignal 117 additiv verbunden, wobei hiervon noch das Kompensationssignal 118 subtrahiert wird. Das sich ergebende Signal wird an einen Schleifenfilter 176 geleitet. Der Ausgang des Schleifenfilters 176 wird additiv mit dem Regelsignal 116 verbunden und an einem Multi-Bit Truncator 180 geleitet. Am Ausgang des Multi-Bit Truncators 180 steht das Kompensationssignal 118 an.

Der Delta-Sigma-Modulator 120 nimmt das Sensorsignal 112 und das Kompensationssignal 118 auf und gibt das digitale Ausgangssignal 114 an seinem Ausgang aus. Von dem Sensorsignal 112 wird ein Kraftrückführsignal 142 subtrahiert, die Differenz wird über eine Kette von Modulen mit jeweils einem Eingang und einem Ausgang geleitet. Die Differenz aus Sensorsignal 112 und Kraftrückführsignal 142 ist mit einem Messelement 122 verbunden, der Ausgang vom Messelement 122 ist mit einem Eingang eines Wandlers von Position in Spannung 124 verbunden und ein Ausgang des Wandlers 124 ist mit einem Eingang eines Boxcar-Filters 126 und ein Ausgang des Boxcar-Filters 126 ist mit einem Eingang eines Abtasters 128 verbunden. Das Kompensationssignal 118 wird über einen Digital-Analog-Konverter 140 mit einem Signal am Ausgang des Abtasters 128 additiv verbunden und die Summe an einen Kompensator 132 überübergeben. Ein Ausgang des Kondensators 132 ist mit einem Eingang eines 1-Bit-Quantisierers 134 verbunden. Das digitale Ausgabesignal 114 an einem Ausgang des 1-Bit-Quantisierers 134 wird sowohl an die digitale Kompensationseinheit 170, an die Regeleinheit 150, einen Ausgang des Delta-Sigma-Wandlers 100 und an eine Rückführung innerhalb des Delta-Sigma-Modulators 120 geleitet. Das digitale Ausgabesignal 114 in der Rückführung innerhalb des Delta-Sigma-Modulators 120 ist verbunden mit einem Eingang eines Feedback-Digital-Analog-Konverters 136. Ein Ausgang des Feedback-Digital-Analog-Konverters 136 ist mit einem Eingang eines Spannung-zu-Kraft-Wandlers 138 verbunden. An einem Ausgang des Spannung-zu-Kraft-Wandlers 138 liegt das Kraftrückführsignal 142 an, welches wie oben beschrieben von dem Sensorsignal 112 subtrahiert wird.

Das Blockschaltbild in Fig. 1 eines Ausführungsbeispiels der vorliegenden Erfindung stellt einen schematischen Aufbau eines MEM Delta-Sigma-Wandlers 100 mit einer über das Regelsignal 116 in seiner Varianz einstellbarem weißen Dither-Signal dar.

Fig. 1 zeigt somit einen schematischen Aufbau eines MEM Delta-Sigma Wandlers, mit Dither-Einspeisung, wobei die Figur 1 auf einer Abbildung aus der Dissertation Chinwuba Ezekwe, "Readout Techniques for High-Q Micromachined Vibratory Rate Gyroscopes" beruht und um die spezifischen Elemente der erfindungsgemäßen Lösung erweitert wurde, speziell um die Regeleinheit 150, die die Aktivität bestimmt und damit den Dither 116 regelt.)

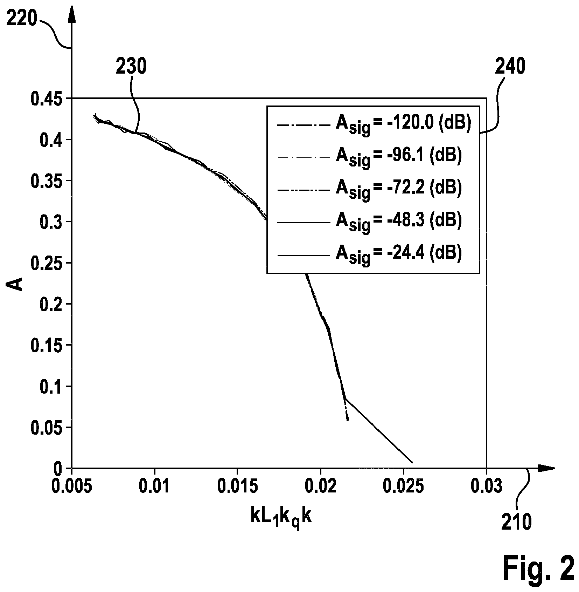

Der Aufbau besteht aus dem MEM Delta-Sigma Wandler 100 und der Einheit zur Bestimmung der Aktivität 150. Falls als Anzahl möglicher Zustandsänderungen ein Wert aus 2^{N} verwendet wird, kann die Aktivität sehr einfach durch einen Zähler, der die Anzahl der Zustandsänderungen zählt, bestimmt werden. Zur Verdeutlichung sei folgendes Beispiel genannt: Der Quantisierer 134 besitzt folgenden Ausgangsdatenstrom [-1 1 1 1 -1 -1 1 1 1], wobei ein Wert -1 eine Sprung von einem hohen Pegelwert auf einen niedrigen Pegelwert und ein Wert 1 einen Sprung voneinem niedrigen Pegelwert zu einem hohen Pegelwert beschreibt. Die Anzahl der möglichen Zustandsänderungen ist 8. Die Anzahl der Zustandsänderungen ist 3. Somit ergibt sich eine Aktivität von 0,375. Zusammen mit den Informationen aus der nachfolgend näher beschriebenen Darstellung aus Fig. 2 kann dann auf die Schleifenverstärkung ∥kq L1(z)∥ zurückgeschlossen werden, welche in dem obigen Beispiel 0,0125 entspräche. Aus der Systemauslegung des MEM-Delta-Sigma-Modulators 120 kann, zum Beispiel, zu ∥k_{q} L₁(z)∥ = 0,01 als optimaler Wert bestimmt worden sein. Somit müsste in diesem Fall das Dithersignal 116 derart angepasst werden, dass die Aktivität gleich 0,40 entspricht. Diese Anpassung lässt sich manuell oder auch per PI-Regler erreichen, wie in Fig. 1 dargestellt. In Fig. 1 nicht dargestellt ist eine weitere günstige Ausführungsform mit einer Verwendung einer aktiven Regelung, welche die Aktivität, d.h. die Häufigkeit der Signalpegeländerungen 153 auf einen konstanten Wert hält, dies ist möglich am Band-Ende und im laufenden Betrieb.

Fig. 2 zeigt eine Simulation der Aktivität des Quantisierers 220 für verschiedene Schleifenverstärkungen, Dither-Werte und Restesignale. Wie zu erkennen ist, würde ein vorhandenes Drehraten- / Quadratursignal zu keiner fehlerhaften Schätzung führen. Diese Abbildungsfunktion sollte für jeden Wandler neu berechnet werden. Fig. 2 zeigt dabei in einem Koordinatensystem die als Aktivität bezeichnete Häufigkeit von Signalpegelwechseln 220 auf der Ordinate in Abhängigkeit einer Schleifenverstärkung des Sigma-Delta-Wandlers (bzw. Delta-Sigma-Wandlers) 210 auf der Abszisse. Eingezeichnet sind Kennlinien 230 für fünf verschiedene Delta-Sigma-Modulatoren 120. Eine Legende 240 zeigt die 5 verschiedenen eingetragenen Kennlinien.

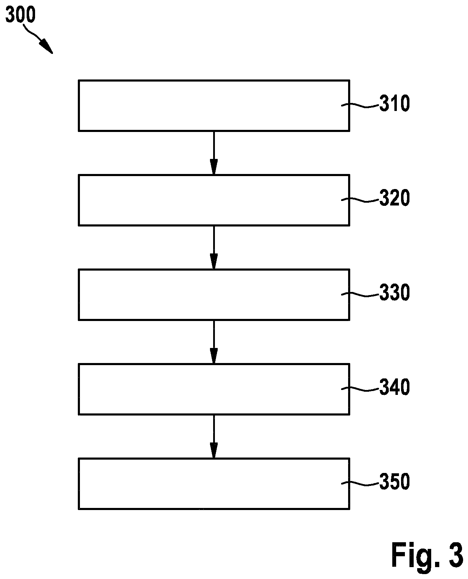

Fig. 3 zeigt ein Ablaufdiagramm eines Ausführungsbeispiels der vorliegenden Erfindung als Verfahren 300 zur Erzeugung eines digitalen Ausgangssignals unter Verwendung eines Sensorsignals. Das Verfahren 300 umfasst einen Schritt des Einlesens 310 eines Sensorsignals und einen Schritt des Delta-Sigma-Wandelns 320 des Sensorsignals in ein digitales Ausgangssignal. Weiterhin umfasst das Verfahren 300 einen Schritt des Bereitstellens 330 eines Regelsignals unter Verwendung einer Häufigkeit von Signalpegelwechseln des digitalen Ausgangssignals und einen Schritt des Ermittelns 340 eines Kompensationssignals unter Verwendung des digitalen Ausgangssignals und des Regelsignals. Schließlich umfasst das Verfahren 300 einen Schritt des Veränderns 350 des digitalen Ausgangssignals unter Verwendung des Kompensationssignals.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können erfindungsgemäße Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Delta-Sigma-Wandler (100) für ein Sensorsignal (112), insbesondere ein Signal eines Drehratensensors,
wobei der Delta-Sigma-Wandler (100) ausgebildet ist, um ein digitales Ausgabesignal (114) unter Verwendung des Sensorsignals (112) und eines 1-Bit-Quantisierers (134) auszugeben,
wobei der Delta-Sigma-Wandler (100) eine Regeleinheit (150) aufweist, die ausgebildet ist, um ein Regelsignal (116) auf der Basis einer eine Aktivität repräsentierende Häufigkeit von Signalpegelwechseln (153) des digitalen Ausgabesignals (114) in einem betrachteten Zeitintervall zu erzeugen,
wobei die Aktivität des Quantisierers eine direkte Korrelation zur vorhandenen Schleifenverstärkung besitzt,
und wobei der Delta-Sigma-Wandler (100) eine digitale Kompensationseinheit (170) aufweist, die ausgebildet ist, um ein Kompensationssignal (118), unter Verwendung des digitalen Ausgabesignals (114) und des Regelsignals (116) auszugeben, wobei die digitale Kompensationseinheit (170) ausgebildet ist, um ein in seiner Varianz anpassbares Dithersignal als Kompensationssignal (118) auszugeben,
wobei der Delta-Sigma-Wandler (100) weiterhin ausgebildet ist, das digitale Ausgabesignal (114) ferner unter Verwendung des Kompensationssignals (118) zu ermitteln und
wobei der Delta-Sigma-Wandler (100) einen Aktivitätszähler (152) zur Bestimmung der Häufigkeit von Signalpegelwechseln (153) aus dem digitalen Ausgabesignal (114) aufweist, der ausgebildet ist, um eine Anzahl von Signalpegelwechseln (153) des digitalen Ausgabesignals (114) zu zählen
**dadurch gekennzeichnet, dass** die Regeleinheit (150) ausgebildet ist, um damit das Regelsignal (116) zu erzeugen, um die Aktivität auf einen definierten Wert einzustellen.

2. Delta-Sigma-Wandler (100) gemäß Anspruch 1, mit einem kraftkompensierten Sensor zur Bereitstellung des Sensorsignals (112).

3. Delta-Sigma-Wandler (100) gemäß einem der vorangegangenen Ansprüche, bei dem die Regeleinheit (150) ausgebildet ist, um das Regelsignal (116) unter Verwendung einer Kennlinie zu bestimmen.

4. Delta-Sigma-Wandler (100) gemäß Anspruch 3, bei dem die Kennlinie eine Häufigkeit von Signalpegelwechseln (153) des digitalen Ausgabesignals (114) in Abhängigkeit einer Schleifenverstärkung des Delta-Sigma-Wandlers (100) repräsentiert.

5. Delta-Sigma-Wandler (100) gemäß einem der vorangegangenen Ansprüche, bei dem die Regeleinheit (150) ausgebildet ist, das Regelsignal (116) derart zu bestimmen, dass es einer veränderbaren Varianz eines Dither-Rauschens entspricht.

6. Delta-Sigma-Wandler (100) gemäß einem der vorangegangenen Ansprüche, bei dem die Regeleinheit (150) ausgebildet ist, um das Regelsignal (116) unter Verwendung eines gleitendenden Mittelwerts der Häufigkeit von Signalpegelwechseln (153) des digitalen Ausgabesignals (114) zu bestimmen.

7. Verfahren zur Erzeugung eines digitalen Ausgangssignals (114) unter Verwendung eines Sensorsignals (112), welches die folgenden Schritte umfasst:
- Einlesen eines Sensorsignals (112);
- Delta-Sigma-Wandeln (120) des Sensorsignals (112) in ein digitales Ausgangssignal (114) unter Verwendung eines 1-Bit-Quantisierers (134);
- Bereitstellen eines Regelsignals (116) unter Verwendung einer eine Aktivität repräsentierende Häufigkeit von Signalpegelwechseln (153) des digitalen Ausgangssignals (114) in einem betrachteten Zeitintervall, wobei zur Bestimmung der Häufigkeit von Signalpegelwechseln (153) aus dem digitalen Ausgabesignal (114) ein Aktivitätszähler (152) verwendet wird, der ausgebildet ist, um eine Anzahl von Signalpegelwechseln (153) des digitalen Ausgabesignal (114) zu zählen wobei die Regeleinheit (150) damit das Regelsignal (116) erzeugt, um die Aktivität auf einen definierten Wert einzustellen und wobei die Aktivität des Quantisierers eine direkte Korrelation einer vorhandenen Schleifenverstärkung besitzt;
- Ermitteln eines Kompensationssignals (118) unter Verwendung des digitalen Ausgangssignals (114) und des Regelsignals (116), wobei das Kompensationssignal (118) eine in seiner Varianz anpassbares Dithersignal repräsentiert; und
- Verändern des digitalen Ausgangssignals (114) unter Verwendung des Kompensationssignals (118).

8. Computer-Programmprodukt mit Programmcode, das bewirkt, dass der Delta-Sigma-Wandler nach Anspruch 1 das Verfahren nach Anspruch 7 durchführt.

## Claims

1. Delta-sigma converter (100) for a sensor signal (112), in particular a signal of a rotation rate sensor,
wherein the delta-sigma converter (100) is designed to output a digital output signal (114) using the sensor signal (112) and a 1-bit quantizer (134),
wherein the delta-sigma converter (100) has a control unit (150) that is designed to generate a control signal (116) based on a frequency of signal level changes (153) of the digital output signal (114) representing an activity in a considered interval of time,
wherein the activity of the quantizer has a direct correlation to the existing loop gain,
and wherein the delta-sigma converter (100) has a digital compensation unit (170) that is designed to output a compensation signal (118) using the digital output signal (114) and the control signal (116), wherein the digital compensation unit (170) is designed to output a dither signal whose variance is adjustable as compensation signal (118),
wherein the delta-sigma converter (100) is furthermore designed to ascertain the digital output signal (114) further using the compensation signal (118), and
wherein the delta-sigma converter (100) has an activity counter (152) for determining the frequency of signal level changes (153) from the digital output signal (114), which activity counter is designed to count a number of signal level changes (153) of the digital output signal (114), **characterized in that**
the control unit (150) is designed to thus generate the control signal (116) in order to set the activity to a defined value.

2. Delta-sigma converter (100) according to Claim 1, having a force-compensated sensor for providing the sensor signal (112).

3. Delta-sigma converter (100) according to one of the preceding claims, in which the control unit (150) is designed to determine the control signal (116) using a characteristic curve.

4. Delta-sigma converter (100) according to Claim 3, in which the characteristic curve represents a frequency of signal level changes (153) of the digital output signal (114) as a function of a loop gain of the delta-sigma converter (100).

5. Delta-sigma converter (100) according to one of the preceding claims, in which the control unit (150) is designed to determine the control signal (116) such that it corresponds to a changeable variance in dither noise.

6. Delta-sigma converter (100) according to one of the preceding claims, in which the control unit (150) is designed to determine the control signal (116) using a sliding average of the frequency of signal level changes (153) of the digital output signal (114).

7. Method for generating a digital output signal (114) using a sensor signal (112), which comprises the following steps:
- reading in a sensor signal (112);
- delta-sigma conversion (120) of the sensor signal (112) into a digital output signal (114) using a 1-bit quantizer (134);
- providing a control signal (116) using a frequency of signal level changes (153) of the digital output signal (114) representing an activity in a considered interval of time, wherein an activity counter (152) is used to determine the frequency of signal level changes (153) from the digital output signal (114), which activity counter is designed to count a number of signal level changes (153) of the digital output signal (114), wherein the control unit (150) thus generates the control signal (116) in order to set the activity to a defined value, and wherein the activity of the quantizer has a direct correlation to an existing loop gain;
- ascertaining a compensation signal (118) using the digital output signal (114) and the control signal (116), wherein the compensation signal (118) represents a dither signal whose variance is adjustable; and
- changing the digital output signal (114) using the compensation signal (118).

8. Computer program product having program code which causes the delta-sigma converter according to Claim 1 to carry out the method according to Claim 7.

## Revendications

1. Convertisseur delta-sigma (100) destiné à un signal de capteur (112), en particulier à un signal provenant d'un capteur de vitesse de rotation,
le convertisseur delta-sigma (100) étant conçu pour délivrer un signal de sortie numérique (114) à l'aide du signal de capteur (112) et d'un quantificateur à 1 bit (134),
le convertisseur delta-sigma (100) comportant une unité de régulation (150) qui est conçue pour générer un signal de régulation (116) sur la base d'une fréquence, représentant une activité, de changements de niveau de signal (153) du signal de sortie numérique (114) dans un intervalle de temps considéré,
l'activité du quantificateur présentant une corrélation directe avec le gain de boucle existant,
et le convertisseur delta-sigma (100) comportant une unité de compensation numérique (170) qui est conçue pour délivrer un signal de compensation (118) à l'aide du signal de sortie numérique (114) et du signal de régulation (116), l'unité de compensation numérique (170) étant conçue pour délivrer comme signal de compensation (118) un signal de vibration adaptable en variance,
le convertisseur delta-sigma (100) étant en outre conçu pour déterminer le signal de sortie numérique (114) également à l'aide du signal de compensation (118) et le convertisseur delta-sigma (100) comportant un compteur d'activité (152) qui est destiné à déterminer la fréquence de changements de niveau de signal (153) à partir du signal de sortie numérique (114) et qui est conçu pour compter un certain nombre de changements de niveau de signal (153) du signal numérique de sortie (114), **caractérisé en ce que**
l'unité de régulation (150) est conçue pour générer le signal de régulation (116) afin de régler l'activité à une valeur définie.

2. Convertisseur delta-sigma (100) selon la revendication 1, comprenant un capteur compensé en force qui est destiné à fournir le signal de capteur (112).

3. Convertisseur delta-sigma (100) selon l'une des revendications précédentes, dans lequel l'unité de régulation (150) est conçue pour déterminer le signal de régulation (116) à l'aide d'une caractéristique.

4. Convertisseur delta-sigma (100) selon la revendication 3, dans lequel la caractéristique représente une fréquence de changements de niveau de signal (153) du signal numérique de sortie (114) en fonction d'un gain de boucle du convertisseur delta-sigma (100) .

5. Convertisseur delta-sigma (100) selon l'une des revendications précédentes, l'unité de régulation (150) est conçue pour déterminer le signal de régulation (116) de manière à ce qu'il corresponde à une variance variable d'un bruit de vibrations.

6. Convertisseur delta-sigma (100) selon l'une des revendications précédentes, dans lequel l'unité de régulation (150) est conçue pour déterminer le signal de régulation (116) à l'aide d'une moyenne mobile de la fréquence de changements de niveau du signal (153) du signal de sortie numérique (114).

7. Procédé de génération d'un signal de sortie numérique (114) à l'aide d'un signal de capteur (112), lequel procédé comprend les étapes suivantes :
- lire un signal de capteur (112) ;
- effectuer une conversion delta-sigma (120) du signal de capteur (112) en un signal de sortie numérique (114) à l'aide d'un quantificateur à 1 bit (134) ;
- fournir un signal de régulation (116) à l'aide d'une fréquence, représentant une activité, de changements de niveau de signal (153) du signal de sortie numérique (114) dans un intervalle de temps considéré, un compteur d'activité (152), qui est conçu pour compter un certain nombre de changements de niveau de signal (153) du signal de sortie numérique (114), étant utilisé pour déterminer la fréquence de changements de niveau de signal (153) à partir du signal de sortie numérique (114), l'unité de régulation (150) générant ainsi le signal de régulation (116) afin de régler l'activité à une valeur définie et l'activité du quantificateur présentant une corrélation directe avec un gain de boucle existant ;
- déterminer un signal de compensation (118) à l'aide du signal de sortie numérique (114) et du signal de régulation (116), le signal de compensation (118) représentant un signal de vibration adaptable en variance ; et
- modifier le signal de sortie numérique (114) à l'aide du signal de compensation (118).

8. Progiciel contenant un code de programme qui amène le convertisseur delta-sigma de la revendication 1 à mettre en œuvre le procédé de la revendication 7.
